# EUROPEAN PATENT SPECIFICATION

(11) **EP 1 863 077 B1**
(45) Date of publication and mention of the grant of the patent: **14.08.2013**
(21) Application number: 07008890.1
(22) Date of filing: 02.05.2007
(51) Int. Cl.: H01L 21/66

(54) **Substrate inspecting method and methods of manufacturing an element and a substrate**
Substratprüfungsverfahren und Verfahren zur Herstellung eines Elements und eines Substrats
Procédé d'inspection de substrats et procédés de fabrication d'un élément et d'un substrat

(30) Priority: 01.06.2006 JP 2006153555; 24.01.2007 JP 2007014172
(43) Date of publication of application: 05.12.2007
(73) Proprietor: Sumitomo Electric Industries, Ltd., Osaka-shi, Osaka 541-0041 (JP)
(72) Inventor: Nakamura, Takao, Itami-shi Hyogo 664-0016 (JP); Ueda, Toshio, Itami-shi Hyogo 664-0016 (JP); Kyono, Takashi, Itami-shi Hyogo 664-0016 (JP)
(74) Representative: Grünecker, Kinkeldey, Stockmair & Schwanhäusser

(56) References cited:
- EP-A- 0 295 065
- JP-A- 2000 021 824
- US-A- 6 031 229
- US-A1- 2005 003 572
- US-A1- 2005 012 512
- US-A1- 2005 039 673
- US-B1- 6 329 667
- US-B1- 6 972 201

## Description

### BACKGROUND OF THE INVENTION

### Field of the Invention

The present invention relates to a substrate, a substrate inspecting method and methods of manufacturing an element and a substrate, and particularly to a substrate provided at its surface with a high-quality layer, a substrate inspecting method and methods of manufacturing an element and a substrate using the substrate inspecting method.

### Description of the Background Art

Semiconductor devices having substrates of Si have been known. In a process of manufacturing such semiconductor devices, various characteristics such as a carrier concentration are inspected for determining whether the characteristics of the produced semiconductor device satisfy predetermined criterions or not (see, e.g., Japanese Patent Laying-Open No. 2001-24041).

It is also known that so-called wide band gap semiconductors such as GaN, AlN or SiC are used in optical devices such as an LD as well as power devices using a schottky barrier diode (SBD) or the like. In a method of manufacturing such devices, an epitaxial growth layer is first formed on a surface of a substrate made of a wide band gap semiconductor, and then a non-destructive inspection such as PL (Photo-Luminescence) measurement is executed on the substrate provided with the epitaxial growth layer thus formed for determining a film quality and the like of the epitaxial growth layer, similarly to a conventional manufacturing processing of a semiconductor device. However, this non-destructive inspection can provide only information relating to a surface and its vicinity of the epitaxial growth layer. For executing a necessary inspection on the whole epitaxial growth layer, a destructive inspection such as carrier concentration measurement by a CV method and/or PL measurement is executed on each layer in the epitaxial growth layer by cutting the substrate.

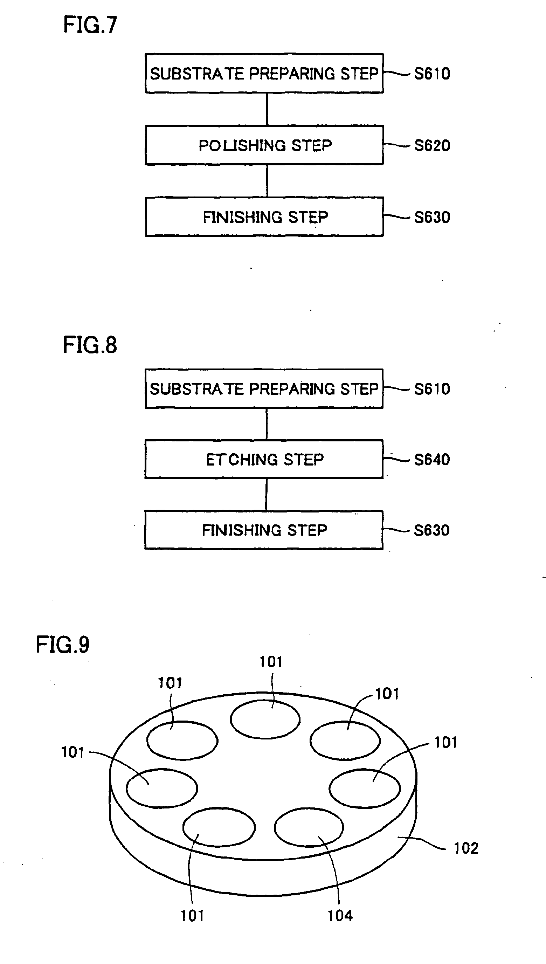

The non-destructive inspection can be executed on all the substrates of the same epitaxy batch (i.e., all the substrates formed in the same epitaxial growth step). However, the destructive inspection cannot be executed on all the substrates. For executing the destructive inspection, therefore, it is necessary to arrange a substrate for the destructive inspection together with the substrates for final products in the same batch, and it is necessary to form the epitaxial growth layer on the substrate for the destructive inspection similarly to the other substrates. For example, as shown in Fig. 9, a plurality of (seven in Fig. 9) substrates 101 and 104 are arranged on a susceptor 102, and epitaxial growth layers are simultaneously formed on these substrates 101 and 104 in one epitaxial growth step (in the case of a multi-work batch). In this case, six substrates 101 will become products, but one substrate 104 is used as a substrate for the destructive inspection. Fig. 9 schematically shows the multi-work batch, and particularly shows a state in which the plurality of substrates are arranged on the susceptor. In particular, there is a tendency that the substrates for inspection increase with increase in size of an epitaxial growth furnace.

The substrate made of the foregoing wide band gap semiconductor is very expensive as compared with the conventional substrates of Si, GaAs, InP and the like due to its manufacturing method and yield. Therefore, in the device manufactured using such a relatively expensive substrate, a rate of a substrate cost to a manufacturing cost is higher than that in the conventional device. Thus, the product (i.e., device) requires the substrate that is used only for the destructive inspection and cannot be used for obtaining the product, and this is one of causes that increase the total cost of the product.

Since the destructive inspection is performed on only the substrate employed only for the destructive inspection, qualities of portions of the epitaxial growth layers (which may also be referred to as "epitaxial layers" hereinafter) other than the surface portions are not determined in all the substrates. Therefore, it is difficult to ensure the quality of the epitaxial growth layer with high precision, and this results in lowering of yield of the devices.

Document JP 2000-021824 relates to a layer opening method in the local region of a semiconductor element, by polishing an arbitrary part on the element for observation. The methods provided in this document, however, do not disclose or suggest the feature of etching away the plurality of layers up to a predetermined depth and simultaneously executing a composition analyzing step.

Document US 2005/0012512 A1 relates to a system and a method for detecting a milling endpoint on a semiconductor sample by directing an iron beam from a focused iron beam (FIB) apparatus at the sample and using charge pulse detection electronics (CPDE) components to generate a distribution curve on a histogram display. The present invention, however, differs in terms of the process used in the etching and the composition analyzing step.

### SUMMARY OF THE INVENTION

An object of the invention is to provide a substrate inspection method that can inspect all substrates each provided at its surface with a plurality of layers by determining qualities of the plurality of layers as well as methods of manufacturing a substrate and an element using the substrate inspection method.

Another object of the invention is to provide a substrate of a high quality that is determined by executing the substrate inspection method according to the invention on a layer formed at a surface of the substrate.

This objects are solved by the features of claims 1, 4 and 5.

According to the above manner, the opening is formed at only a portion of the region, where the plurality of layers are formed, of the main surface of the substrate, and one or more inspections can be performed on the layer exposed in the opening by PL measurement or CV method. The formation of the opening allows the inspection of the inner region at an arbitrary depth of the layer in contrast to the case where the inspection is performed on only the surface and its vicinity of the layer that can be inspected by the conventional non-destructive inspection. Therefore, evaluation can be performed directly as compared with the case where only the non-destructive inspection is performed on the layer formed at the main surface of the substrate, and therefore the substrate having an ensured high quality can be obtained.

The opening is formed in the region provided with the plurality of layers, and the inspection is performed in the opening. Therefore, an element can be formed in a portion of the region provided with the plurality of layers except of the portion provided with the opening. Also, the element can be formed on the substrate that is subjected to the inspection. In contrast to the conventional method, therefore, the element manufacturing method does not require a substrate that is to be used only for a destructive inspection and cannot be used for obtaining the element. Therefore, the substrate inspection method according to the invention can prevent waste of the whole substrate for the inspection, and consequently can suppress increase of the manufacturing cost of the elements. The invention can be used particularly effectively for the case of using a wide band gap semiconductor.

The end portion represents an area in the region provided with the plurality of layers, and particularly an area within 5 mm, and more preferably 4 mm from an outer edge of the above region. For example, in the case where the plurality of layers are formed at the whole main surface of the substrate, the end where the opening is formed represents an outer peripheral portion of the substrate and particularly the portion within 5 mm, and more preferably 4 mm from an outer periphery of the substrate. The opening is a concavity that is formed by removing at least partially the uppermost layer among the plurality of layers in an arbitrary manner such as etching, and has a diameter, e.g., between 1mm and 4 mm, and more preferably between 2 mm and 3 mm. The inspection may be any inspection for measuring characteristics of the layer exposed in the opening. For example, the inspection can be executed by carrier concentration measurement in the CV method, optical measurement by the PL measurement, measurement of crystallinity or the like of the layer by the X-ray diffraction method or the like. The foregoing processing step and the inspection step may be executed simultaneously. For example, while the processing step is being executed by partially removing the layer by plasma etching, components of a removed layer may be analyzed by executing light emission analysis on the light that is emitted by the plasma etching. As described above, it is desired that the opening is formed at the end portion of the region provided with the plurality of layers, but the opening may be formed at any position in the region when necessary. For example, the opening may be formed at a center of the above region. By forming the opening at the center of the region as described above, the method can measure typical characteristics of the plurality of layers more accurately than the case where the opening is formed at the end portion.

In the method of manufacturing an element, the element can be obtained even from the substrate subjected to the inspection so that the substrates can be used effectively. Consequently, the manufacturing cost of the elements obtained from the substrates can be lower than that in the case where the element cannot be obtained from the substrate subjected to the inspection.

A method of manufacturing a substrate can reform the plurality of layers on the substrate that is determined not to satisfy the predetermined criterion in the inspection step. Therefore, such a situation does not occur that the expensive substrate is abandoned due to a failure relating to the plurality of layers, and the substrates can be effectively used.

The foregoing and other objects, features, aspects and advantages of the present invention will become more apparent from the following detailed description of the present invention when taken in conjunction with the accompanying drawings.

### BRIEF DESCRIPTION OF THE DRAWINGS

Fig. 1 is a flowchart illustrating an element manufacturing method according to the invention.
Fig. 2 is a flowchart illustrating details of an inspection step illustrated in Fig. 1.
Fig. 3 is a flowchart illustrating a local destructive inspection step illustrated in Fig. 2.
Fig. 4 is a schematic perspective view of a substrate subjected to the inspection step illustrated in Fig. 1.
Fig. 5 is a schematic cross section taken along line V-V in Fig. 4.
Fig. 6 is a schematic perspective view of the substrate provided with elements formed in a post-treatment step in Fig. 1.
Fig. 7 is a flowchart illustrating an example of an epitaxial layer removing step in Fig. 1.
Fig. 8 is a flowchart for illustrating another example of the epitaxial layer removing step in Fig. 1.
Fig. 9 schematically shows a state in which a plurality of substrates are arranged on a susceptor for multi-work batch processing.

### DESCRIPTION OF THE PREFERRED EMBODIMENTS

Embodiments of the invention will now be described with reference to the drawings. In the following description and drawings, the same or corresponding portions bear the same reference numbers, and description thereof is not repeated.

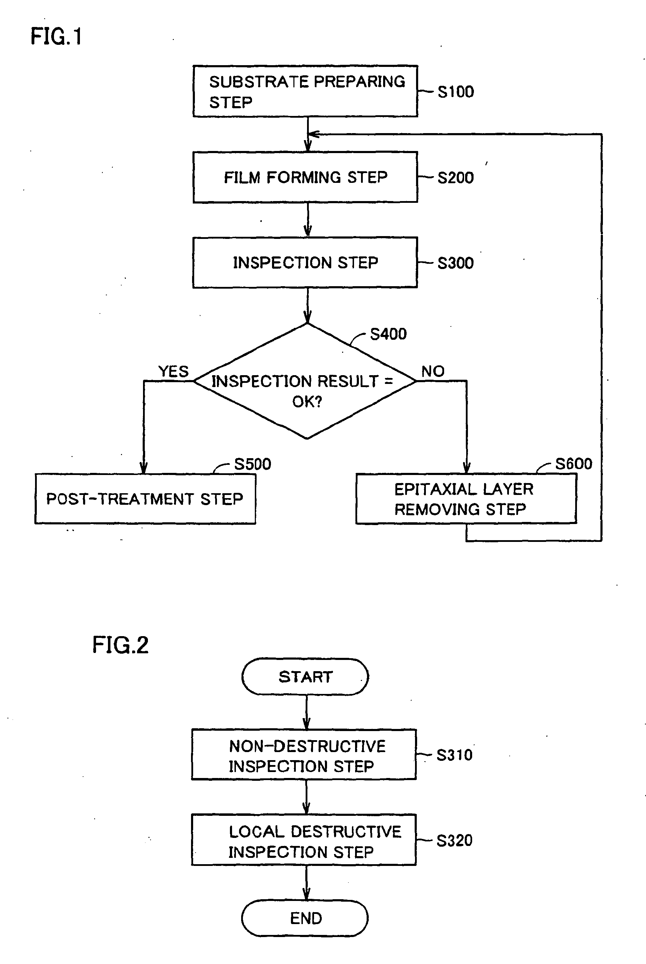

Referring to Figs. 1 to 8, a method of manufacturing an element according to the invention will now be described.

As shown in Fig. 1, the method of manufacturing the element according to the invention uses a substrate manufacturing method or a substrate inspection method according to the invention, and is started by executing a substrate preparing step (S100). In this substrate preparing step (S100), a substrate, e.g., of GaN is prepared. An AlN substrate or an SiC substrate may be prepared.

Then, a film forming step (S200) is executed. More specifically, an epitaxial growth method is executed to form a plurality of epitaxial films made of AlGaN, InGaN and/or the like on a main surface of the substrate. Ten or more epitaxial films are formed as layers.

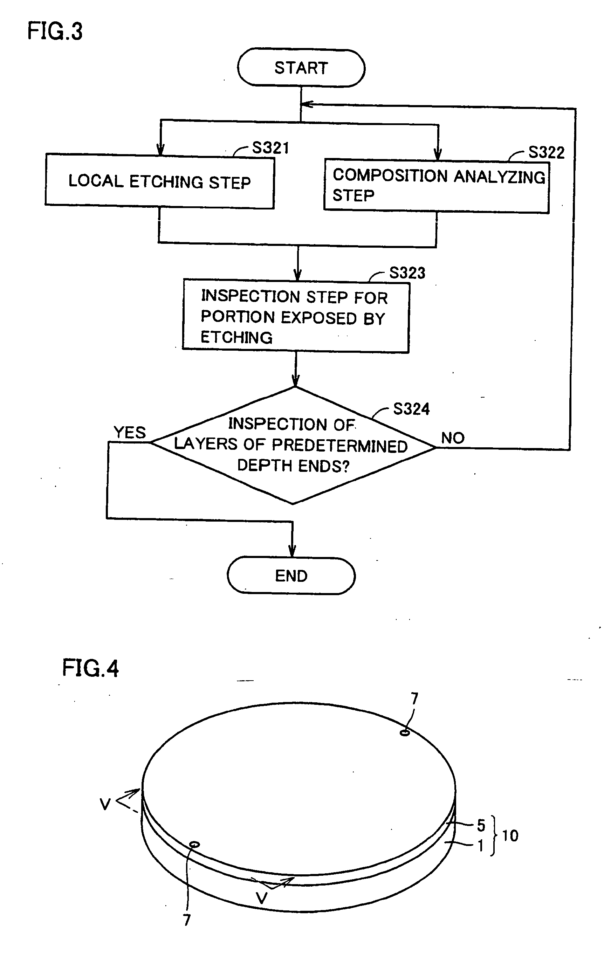

Then, an inspection step (S300) is executed. More specifically, as illustrated in Fig. 2, a non-destructive inspection step (S310) is executed, and then a local destructive inspection step (S320) is executed. In the non-destructive inspection step (S310), a surface characteristic inspection by a visual inspection or with a predetermined inspection device is performed on the uppermost layer among the plurality of epitaxial films formed in the film forming step (S200), and further PL measurement and measurement by the X-ray diffraction method are performed on the above uppermost layer. Then, the local destructive inspection step (S320) is executed. Details of this local destructive inspection step (S320) are specifically illustrated in Fig. 3.

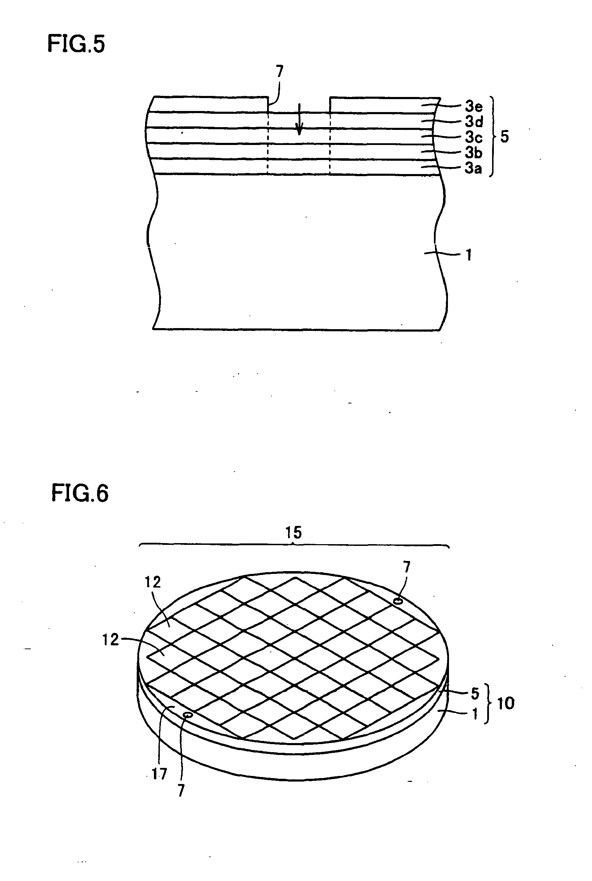

As illustrated in Fig. 3, a local etching step (S321) is first executed in the local destructive inspection step (S320). In the local etching step (S321), as illustrated in Figs.4 and 5, a portion of a predetermined depth from an epitaxial film 3e of an uppermost layer is removed from epitaxial layers 5 formed of epitaxial films 3a - 3e layered on the main surface of a substrate 1 by an appropriate etching method. The etching depth may be adjusted by controlling process conditions such as an etching time. Fig. 5 shows an example in which only epitaxial film 3e of the uppermost layer is removed by the etching to form a concavity 7 serving as an opening. In Fig. 5, an upper surface of epitaxial film 3d that is a second layer in epitaxial layers 5 is exposed at the bottom of concavity 7. The etching method may be executed by plasma etching or etching using glow discharge. The etching time may be adjusted to increase the depth in the direction of an arrow in Fig. 5, or to decrease it in the direction opposite to the arrow. This etching step (S321) may employ any etching method provided that it can form a small concavity of 1 mm - 4 mm in diameter.

A composition analyzing step (S322) is executed simultaneously with the local etching step (S321). In this composition analyzing step (S322), predetermined physical quantities are measured from a portion removed from epitaxial layers 5 in the local etching step (S321), and thereby the composition of this portion (e.g., epitaxial film 3e) of the epitaxial layer 5 is analyzed. For example, when plasma etching is performed in the local etching step (S321), light emission analysis is performed on the plasma in this etching process to measure the compositions in the depth direction of the portion removed from epitaxial layers 5 by the plasma etching. When the etching is performed using the glow discharge in the local etching step (S321), the glow discharge causes excitation and light emission of component atoms of the portion that is removed from epitaxial layers 5 by the etching. The emitted light indicate wavelengths peculiar to the respective kinds of atoms, and the intensity of the light is proportional to the quantity of the atoms. Therefore, the composition in the depth direction of the portion of epitaxial layers 5 can be detected by measuring the wavelengths and intensities of the light.

Then, an inspection step (S323) is executed on the portion exposed by the etching. More specifically, in this step (S323), the CV measurement is performed to measure a carrier concentration of the inner layer (epitaxial film 3d in Fig. 5) of epitaxial layers 5, i.e., the layer exposed at the bottom of concavity 7 formed in the above step (S321). Before executing the CV measurement, the surface of the measurement target layer (epitaxial film 3d in Fig. 5) is slightly removed by etching using an etching liquid or an electrochemical action. Thereafter, the PL measurement is performed on the layer thus etched, and more specifically, micro-PL measurement is performed on a minute region such as a bottom of concavity 7. Thereby, the optical characteristics of the target layer are evaluated.

Then, a step (S324) is executed to determine whether the inspection has reached a predetermined depth of the layers or not. In this step (S324), it may be determined, for example, whether a total value of process condition data such as an etching time in the local etching step (S321) (e.g., a total time of the etching when the etching time is to be used as the process condition data) exceeded a predetermined reference value or not, whereby it may be determined whether concavity 7 has a bottom at a predetermined depth or not (more specifically, e.g., concavity 7 extending through epitaxial layers 5 is formed to expose the upper surface of substrate 1 or not). Alternatively, a direct measuring method may be executed to measure the depth of concavity 7 by a measuring device such as a direct step gauge.

When it is determined in this step (S324) that the inspection has not reached a predetermined depth of the layers (NO), the steps (S321 and S322) and the following step are repeated as illustrated in Fig. 3. When it is determined in the step (S324) that the inspection has reached a predetermined depth of the layers (YES), the local destructive inspection step (S320) ends.

When one substrate has the plurality of concavities 7, the local destructive inspection step (S320) for each concavity 7 may be repeated. In this case, the same kind of inspection may be repeated for the plurality of concavities 7, or each concavity may undergo the inspection different from the inspections for the other concavities. For example, one (first opening) of concavities 7 may undergo the composition measurement performed in the depth direction in a continuous manner, and another concavity 7 (second opening) may undergo the CV measurement and the PL measurement performed successively for each layer.

When the inspection step (S300) ends, a step (S400) is executed to determine whether a result of the inspection satisfies the predetermined criterion or not, as illustrated in Fig. 1. In this step (S400), the data detected in the inspection step (S300) is compared with a predetermined reference value to determine whether the inspection result satisfies the predetermined criterion or not.

When it is determined in the step (S400) that the inspection result does not satisfy the predetermined criterion (NO), an epitaxial layer removing step (S600) is executed. In this step (S600), epitaxial layers 5 are removed from substrate 1 of a wafer 10 (see Fig. 4). For example, etching, polishing or another appropriate manner may be employed for the removal. The epitaxial layer removing step (S600) will be described later in detail. Substrate 1 from which epitaxial layers 5 are removed is processed again in the film forming step (S200) as illustrated in Fig. 1, and is used as the substrate for forming the film thereon. When it is determined in the above step (S400) that the inspection result satisfies the predetermined criterion (YES), this means that produced wafer 10 (see Fig. 4) is provided with epitaxial layers 5 having the predetermined characteristics. When the result of the determination is YES in the step (S400), a post-treatment step (S500) is executed.

In the post-treatment step (S500), a step of forming electrodes of the devices on a surface of epitaxial layer 5, a step of dividing wafer 10 into the chips and other steps are executed for forming devices such as chips. As shown in Fig. 6, concavities 7 formed in the inspection step (S300) are located in peripheral regions 17 outside a chip formation region 15 in which chip regions 12 are formed for providing the respective chips. Therefore, the chips, i.e., the products can be obtained from wafer 10 that has undergone the inspection step (S300).

Referring to Fig. 7, another example of the epitaxial layer removing step (S600) will now be described in detail. As illustrated in Fig. 7, a substrate preparing step (S610) is first executed in the epitaxial layer removing step (S600). In this step (S610), jigs and the like are set for polishing the substrate that is determined not to satisfy the predetermined criterion (and is provided at its surface with the epitaxial film) in the step (S400) from the inspection result. For example, the substrate may be fixed to a fixing table such that a rear surface of the substrate opposite to a polish target surface provided with the epitaxial film is fixed to the fixing table by a holding member (e.g., wax).

Then, a polishing step (S620) is executed. In this polishing step (S620), the surface of the epitaxial film formed on the substrate is polished. This removes at least a part of the epitaxial films. The polishing step (S620) may employ various polishing methods. This polishing step (S620) can remove from the substrate the epitaxial film that is determined not to satisfy the predetermined criterion on the surface of the substrate.

In the polishing step (S620), the polishing may be performed to leave a part of the epitaxial film on the substrate surface. For example, among the epitaxial films formed of the plurality of layers formed on the substrate surface, a quality failure may be present in one or some of the layers on the top surface side (i.e., the layer(s) remote from the substrate surface), but the quality failure is not present in the other layer(s) (e.g., some layers in contact with or near the substrate surface). In this case, only the layer(s) on the top surface side having the failure may be removed in the polishing step (S620). When the epitaxial films formed of the plurality of layers are formed on the substrate, the substrate may warp due to the epitaxial films. The layer(s) causing such warping may be removed in the polishing step (S620). Process conditions (e.g., polish time) in the polishing step may be adjusted so that the epitaxial films of an appropriate thickness (that include a specific epitaxial film having the detected quality failure) may be removed from the substrate surface.

Then, a finishing step (S630) is executed. In this finishing step (S630), the finish processing (finish polishing) is performed on the surface of the substrate (or the top surface of the remaining epitaxial film) that is exposed by the polishing step (S620), and thereby removes a region of the surface where minute defects occurred due to the polishing step (S620). Thus, the finish processing removes a portion having minute holes or a damaged portion. This removal can change the surface to a state that allows film formation by the epitaxial growth method. Thereby, the film forming step (S200) can be executed again as illustrated in Fig. 1.

Referring to Fig. 8, a specific example of the details of the epitaxial layer removing step (S600) will now be described. In this example of the epitaxial layer removing step (S600), the substrate preparing step (S610) is first performed as illustrated in Fig. 8. In this step (S610), the substrate that was determined not to satisfy the predetermined criterion according to the inspection result (NO in step S400) is prepared, similarly to the substrate preparing step (S610) illustrated in Fig. 7. Thus, the substrate provided at its surface with the epitaxial layer is prepared. However, the epitaxial film will be removed by dry etching as will be described later. In the step (S610) illustrated in Fig. 8, therefore, the substrate is arranged, e.g., onto a substrate holder or the like of an etching device. In this step, it is not necessary to fix the substrate on the substrate holder table with wax or the like, in contrast to the step (S610) illustrated in Fig. 7.

Then, an etching step (S640) is executed. In this etching step (S640), the dry etching is performed on the whole surface of the epitaxial film formed on the substrate surface. Thereby, at least a part of the layers of the epitaxial films is removed, similarly to the polishing step (S620) in Fig. 7. The etching step (S640) may employ any etching method provided that it can remove substantially uniformly the whole layer (whole surface) of the epitaxial film. For example, the etching step (S640) may use Reactive Ion Etching (RIE) or another dry etching method. This etching step (S640) can remove from the substrate the epitaxial film that is determined not to satisfy the predetermined criterion on the substrate surface.

In the etching step (S640), a part of the layers of the epitaxial films may be left on the substrate surface, similarly to the polishing step (S620) in Fig. 7. In this case, the thickness of the epitaxial layers to be removed can be changed by adjusting the process conditions such as an etching time. For example, the layer of the epitaxial film to be removed may be different in quality of material from the layer of the epitaxial film to be left. For example, the kinds of atoms of the former may be partially different from those of the latter. In this case, the step is executed by monitoring composition ratios of the atoms contained in a gas discharged from a reaction container of the etching. Thereby, it is possible to detect changes in quality of the film material that is being etched. Therefore, the etching may be stopped when the composition ratios change (i.e., upon start of the etching of the layer of the epitaxial film to be left) so that the layer of the epitaxial film to be removed can be reliably removed.

Then, the finishing step (S630) is executed. This finishing step (S630) is executed substantially in the same manner as the finishing step (S630) illustrated in Fig. 7. Thereby, the surface of the etched substrate enters a state that allows the film formation by the epitaxial growth method so that the film forming step (S200) can be executed again as illustrated in Fig. 1.

### [First Embodiment]

For confirming the effect of the element manufacturing method according to the invention, the following experiments were performed.

In the substrate preparing step (S 100) illustrated in Fig. 1, GaN substrates of 2 inches in diameter were prepared. Each GaN substrate had a thickness of 400 µm. The prepared GaN substrates were six in number.

In the film forming step (S200), an epitaxial layer formed of a plurality of epitaxial films was formed on the main surface of the GaN substrate by the epitaxial growth method. The epitaxial films had compositions and a layer order that were determined for forming a laser diode. The plurality of epitaxial films were formed of GaN (of 2 µm in thickness), n-type Al_{0.07}Ga_{0.93}N (of 1.3 µm in thickness), GaN (of 0.15 µm in thickness), Multi-Quantum Well (MQW), a layered structure of three sets of In_{0.1}Ga_{0.9}N (of 3.5 nm in thickness) and In_{0.02}Ga_{0.98}N (of 7 nm in thickness), GaN (of 0.15 µm in thickness), p-type Al_{0.16}Ga_{0.84}N (of 10 nm in thickness), and eighty sets (of 0.4 µm in total thickness) each of formed of p-type Al_{0.15}Ga_{0.85}N (of 2.5 nm in thickness) and GaN (of 2.5 nm in thickness), which were arranged in this order from the GaN substrate side to form the layered structure.

Then, the inspection step (S300) was executed. In this inspection step (S300), the non-destructive inspection step (S310) was first executed on the epitaxial layer surface of each GaN substrate by performing the PL measurement and measuring the crystallinity of the layer near the epitaxial layer surface using the X-ray diffraction.

Then, the local destructive inspection step (S320) was executed as a part of the inspection step (S300). More specifically, a concavity of 3 mm in diameter was formed at the epitaxial layer surface of each GaN substrate such that the center of the concavity was located in a position spaced from 4 mm from an outer periphery of the GaN substrate. The concavity was formed by etching using glow discharge in the local etching step (S321). When performing the etching, a composition analysis step (S322) was also executed.

Another concavity of 3 mm in diameter was formed in a region different from the region provided with the foregoing concavity such that the center of this concavity was located in a position spaced by 4 mm from the outer periphery of the GaN substrate. For forming this concavity, an Ar gas was supplied into a cylindrical electrode having an inner diameter of 3 mm, and the glow discharge was performed to etch the region where the concavity is to be formed. In this concavity, the etching was successively performed to expose the epitaxial films (p-GaN layer and p-AlGaN layer), that are considered as important films in the epitaxial layers, at the bottom of the concavity. Further, the inspection by the CV method and the PL measurement is performed on the exposed epitaxial films. For example, the etching (corresponding to the step (S321) in Fig. 3) was performed to form the concavity having the bottom where the p-GaN layer was exposed, and the exposed surface portion of the p-GaN layer of 10 nm in thickness was removed by the etching for removing the damaged layer. The thickness of the portion that was removed by the etching for removing the damaged layer may be in a range from 5 nm to 40 nm. The measurement of the carrier concentration by the CV method as well as the PL measurement (corresponding to the step (S323) in Fig. 3) were performed on the foregoing p-GaN layer. In the etching step using the glow discharge, the composition distribution measurement was performed in the depth direction, and simultaneously a dopant concentration of the p-type layer was measured corresponding to the step (S322) in Fig. 3, in addition to the measurement of compositions of the respective layers. In the inspection of the epitaxial films, as described above, the plurality of concavities (holes) were formed for the inspection, the etching was performed on one of the concavities by the glow discharge until this concavity reached the substrate surface, and thereby the composition distribution was evaluated in the depth direction. Through the other concavities (holes), the evaluation was performed on the layers considered as the important layers in the epitaxial layers. This evaluation of the layer considered as the important layer may be performed by successively evaluating the respective layers while increasing the depth of the concavities to expose successively the important layers. Alternatively, different concavities may be formed corresponding to the respective layers considered as the important layers. In this case, the plurality of concavities may have different depths so that the concavities individually expose different important layers, respectively, and the each layer may be evaluated through the corresponding concavity.

Thereafter, the post-treatment illustrated in Fig. 1 can be performed on the substrate provided with the epitaxial layer satisfying the criterion so that the products of the chips can be obtained. An electrode of a three-layer structure formed of palladium (Pd), platinum (Pt) and gold (Au) may be formed on a front surface of the epitaxial growth layer, and an electrode of a three-layer structure formed of titanium (Ti), platinum (Pt) and gold (Au) may be formed on a bottom surface of the GaN substrate.

The above inspection was repeated until all the foregoing films were inspected. When the inspection of all the intended target films was completed (when the result of the determination in the step (S324) in Fig. 3 was YES), the local destructive inspection step (S320) illustrated in Fig. 2 was completed. From the inspection results, it was determined whether each substrate satisfied the predetermined criterion o not. The epitaxial layers of the substrate not satisfying the criterion were removed, and then the substrate was subjected to the steps from the epitaxial layer formation to the inspection again. Thereby, all the substrates could have the epitaxial layers satisfying the criterion. In view of the manufacturing cost, the above inspection may be performed on only one or some of the substrates instead of all the substrates.

### [Second Embodiment]

Then, the following experiment was performed for confirming that the removal step executed in the method of manufacturing the substrate or the element according to the invention (i.e., the step of removing at least partially the layers of the epitaxial films from the substrate provided with the epitaxial films) could provide the substrate on which the epitaxial films could be formed again.

Similarly to the experiment in the first embodiment, GaN substrates of 2 inches in diameter were prepared. Each GaN substrate had a thickness of 400 µm. The prepared GaN substrates were six in number. A warp was measured from each substrate. An average of the measured warps of these substrates was about 1 µm. The warp was measured in the following manner. First, the substrate to be measured was placed on a flat table. A profile of the upper surface of the substrate was measured with a laser displacement gauge. The measurement of the profile was performed along a plurality of line segments extending through the center of the substrate (more specifically, four line segments extending through the center of the substrate and angularly spaced by 45 degrees from each other). In the profile of the substrate surface measured along one line segment, a distance is measured between the straight line passing through the opposite ends corresponding to the outer periphery of the substrate and a position on the profile remotest from this straight line (i.e., a length of such a perpendicular line was measured that extended perpendicularly to the straight line between the straight line and the above remotest position on the profile. The distance thus measured was handled as the value of the warp. On one substrate, the values of the warp were measured from the above four line segments, and the largest value was employed as the warp value of the substrate.

Epitaxial layers formed of a plurality of epitaxial films were formed on the main surface of the GaN substrate by the epitaxial growth method. The epitaxial films had compositions and a layer order determined for forming a laser diode. The plurality of epitaxial films were formed of GaN (of 2 µm in thickness), n-type Al_{0.07}Ga_{0.93}N (of 1.3 µm in thickness), GaN (of 0.15 µm in thickness), Multi-Quantum Well (MQW), a layered structure of three sets of In_{0.1}Ga_{0.9}N (of 3.5 nm in thickness) and In_{0.02}Ga_{0.98}N (of 7 nm in thickness), GaN (of 0.15 µm in thickness), p-type Al_{0.16}Ga_{0.84}N (of 10 nm in thickness), and eighty sets (of 0.4 µm in total thickness) each of formed of p-type Al_{0.15} Ga_{0.85}N (of 2.5 nm in thickness) and GaN (of 2.5 nm in thickness), which were arranged in this order from the GaN substrate side to form the layered structure.

The warps occurred in the substrates provided with the above layered structures. The values of the warps were in a range from 15 µm to 20 µm, and the average value of the six substrates was 18.5 µm.

Three substrates among the six substrates were subjected to polishing for removing the epitaxial films (method 1), and the other three substrates were subjected to dry etching (more specifically, Reactive Ion Etching (RIE)) for removing the epitaxial films (method 2). These methods are specifically as follows.

### (Method 1)

A rear surface of the substrate not covered with the epitaxial film was fixed to a holder plate by wax. The epitaxial film of the substrate fixed to the holder plate was removed by the polishing method. More specifically, in a lapping device, the holder plate holding the substrate was pressed against the platen with the substrate surface faced toward the platen while supplying slurry containing diamond grains in a dispersed fashion to the platen from a slurry supply port. In this state, the holder plate was moved relatively to the platen along the surface of the platen. For example, the holder plate was rotated. In this manner, the polishing (mechanical polishing) was performed on the surface of the substrate provided with the epitaxial films. The grain diameter was reduced stepwise from 2 µm to 1 µm. A polishing pressure by which the holder plate holding the substrate was pressed against the platen was in a range from 100 g/cm² to 500 g/cm². The rotation speed of the holder plate was in a range from 30 rpm to 100 rpm.

Thereafter, the substrate was detached from the holder plate. The detached substrate had nearly no warp, and was in the same state as that before formation of the epitaxial layers. More specifically, the average value of warps of the substrates was 1.2 µm.

However, the substrate fixed to the holder plate had been warped due to formation of the epitaxial film as described before. Therefore, the polishing changed the surface into a flat form while the substrate was in the warped state. When the substrate was no longer warped, the polished substrate surface took the curved form reflecting the state of the warp that had occurred in the substrate before the polishing, and thus the curved form was convexed oppositely to the convex form of the warped substrate.

Since the polished surface of the substrate had minute holes and a damaged layer(s) due to the polishing, epitaxial growth could not be performed as it was. Therefore, finish polishing was performed by a polishing device for improving the flatness of the substrate surface and removing defects such as minute holes and damaged layers described above. More specifically, the polishing device supplied a polishing liquid containing grains in a dispersed fashion from a polishing liquid supply port onto a polishing pad. In this state, the polishing pad was pressed against the curved surface of the fixed substrate, and was rotated relatively thereto. The substrate may be rotated depending on the structure of the polishing device. In this manner, the substrate surface was polished. The grains contained grains of colloidal silica having a grain diameter of 0.1 µm. The polishing liquid contained, as oxidizer, an aqueous solution of sodium carbonate having a pH of 9.5. The polishing pressure by which the polishing pad was pressed against the substrate surface was in a range from 200 g/cm² to 1000 g/cm², and the rotation speed of the polishing pad was in a range from 20 rpm to 90 rpm. The resultant substrate surface had a surface roughness Ra of 0.15 nm on average and a warp of 1 µm on average.

On the surface of the substrate thus polished, the epitaxial layers formed of the plurality of epitaxial films could be formed again by the epitaxial growth method, similarly to the manner executed before the polishing step.

### (Method 2)

First, the substrate was placed on the substrate holder table in the etching device, which was an ICP (Inductively Coupled Plasma) RIE device. Reactive ion etching was performed to remove the epitaxial film on the substrate in the following conditions. An etching gas was a chlorine gas (Cl₂ gas). A region (i.e., an inner space of a reaction container of the RIE device) in which the etching was performed was in a range from 0.3 Pa to 3 Pa. The RF power was in a range from 1000 W to 1200 W, and a bias was 50 W.

Thereafter, the warp of the substrate was measured. The warp of the substrate had been restored to the state before formation of the epitaxial film. More specifically, the value of the warp of the substrate was 1 µm on average. The etching described above was performed on the whole surface of the epitaxial film with substantially the uniform conditions (i.e., isotropically). Therefore, the portion removed by the etching had substantially the uniform thickness over the whole surface of the substrate regardless of the fact that the substrate had warped to a certain extent. Therefore, when the etching was used for removing the epitaxial film, the surface did not have a curved surface in contrast to the foregoing method 1.

Then, similarly to the case of the foregoing method 1, the polishing device performed the finish polishing for removing defects such as minute holes and damaged layers from the substrate. This finish polishing was performed in substantially the same method as the foregoing method 1. Thereafter, the surface roughness and the warp were measured similarly to the method 1. According to the results, the substrate had the surface that allowed epitaxial growth, and thus had a surface roughness similar to that attained by the finish polishing in the method 1 as well as surface characteristics similar to those of an ordinary substrate when measured by the PL measurement. The warp of the substrate was 0.8 µm. The finish polishing in the method 2 did not curve the substrate surface in contrast to the method 1 so that the quantity of polished portion could be smaller than that in the method 1.

By the epitaxial growth method, the epitaxial layers formed of the plurality of epitaxial films could be formed on the substrate surface similarly to the state before the polishing step. More specifically, the epitaxial film of the LED structure was grown on the surface of the substrate, and the PL measurement was performed on the epitaxial film thus formed. The results of such measurement were substantially the same as those obtained from the epitaxial film formed on the ordinary substrate not subjected to repolishing.

The distinctive features of the invention described above can be summarized as follows. The substrate inspection method according to the invention includes a step (the substrate preparing step (S100) and the film forming step (S200) in Fig. 1) of preparing the substrate provided at its main surface with the plurality of layers, the processing step (the local etching step (S321) in Fig. 3), and the inspection step (the inspection step (S323) for the portion exposed by the etching in Fig. 3 or the composition analysis step (S322) in Fig. 3). In the processing step (the local etching step (S321) in Fig. 3), an opening (concavity 7) is formed at the main surface of the substrate by removing at least a part of the plurality of layers (epitaxial layers 5) from an end portion of the region provided with the plurality of layers. In the inspection step (S323), the inspection is performed on the layer (one of epitaxial films 3a - 3e) exposed in concavity 7.

Thereby, concavity 7 is formed only at the end portion of the region where epitaxial films 3a - 3e (i.e., epitaxial layers 5) are formed as the plurality of layers on the main surface of the substrate, and the inspection by the PL measurement and the CV method can be performed on one of epitaxial films 3a - 3e exposed in concavity 7. The formation of concavity 7 allows the inspection of the film in the region at an arbitrary depth inside epitaxial layers 5, in contrast to the case of the conventional non-destructive inspection that allows inspection on only the surface portion of epitaxial layers 5. Therefore, it is possible to obtain the substrate (i.e., wafer 10) provided at its main surface with epitaxial layers 5, which reliably have a higher quality than those of the substrate subjected to only the non-destructive inspection.

Concavity 7 is formed as the opening in the end portion of the region provided with epitaxial layers 5, and the inspection is performed in concavity 7 so that the element can be obtained from the regions where the epitaxial layers 5 are formed, except for the region provided with concavity 7. Thus, even when the substrate underwent the above inspection, the element can be obtained therefrom. Therefore, it is not necessary to prepare a substrate that is used for only a destructive inspection performed for a conventional substrate inspection, and cannot be used for obtaining the element therefrom. By employing the substrate inspection method according to the invention in the manufacturing method of the element, it is not necessary to waste the whole of one substrate for the inspection so that increase in manufacturing cost of the elements can be suppressed.

In the above substrate inspection method, the processing step (step (S321) in Fig. 3) and the inspection step (step (S323) in Fig. 3) may be alternately repeated multiple times as illustrated in Fig. 3. The processing step may be repeated to process the same concavity 7 for changing the depth of concavity 7 to intended values. In this case, the inspection step (S323) may be performed with different depths of concavity 7. Thus, by changing the depth of concavity 7, the inspection step (S323) can be repeated while changing the type of the epitaxial film exposed at the bottom of concavity 7, and thereby the predetermined inspection can be performed on all epitaxial films 3a - 3e, i.e., all the plurality of layers. Therefore, it is possible to obtain the substrate (wafer 10 provided with the epitaxial layers shown in Fig. 4) that is provided at the main surface with the layers reliably having a high quality.

The processing step (local etching step (S321)) in the above substrate inspection method may be executed to form the plurality of openings (concavities 7) at the end portion of the region provided with epitaxial layers 5 as shown in Fig. 4. The number of concavities 7 may be two, three or more. In the inspection step (the inspection step (S323) or composition analysis step (S322) in Fig. 3), the inspection may be performed in each of concavities 7. The processing step (local etching step (S321) and the inspection step (the inspection step (S323) or composition analysis step (S322) in Fig. 3) may be repeated for each of concavities 7. In this case, the inspection may be performed at multiple positions on epitaxial layers 5. Therefore, the inspection of the film quality and the like of epitaxial layers 5 can be performed more reliably.

The element manufacturing method according to the invention includes the inspection step (S300) of performing the inspection of the substrate by the foregoing substrate inspection method, and the element forming step (post-treatment step (S500) in Fig. 1). In the post-treatment step (S500), the element is formed on the substrate that is determined to satisfy the predetermined criterion in the step (S400) in Fig. 1 from the result of the inspection in the inspection step (S300), and particularly the element is formed in the area (chip formation region 15) of the region provided with the plurality of layers (i.e., provided with epitaxial layers 5) other than the area provided with the opening (i.e., concavities 7). Thus, the chip region for producing the elements is formed. In this manner, the elements can be obtained even from the substrate subjected to the inspection step (S300) so that the substrate can be effectively used. Consequently, the manufacturing cost of the elements obtained from the substrate can be lower than that in the case where the element cannot be obtained from the substrate used for the inspection.

The substrate manufacturing method according to the invention includes the step (the substrate preparing step (S 100)) of preparing the substrate, the step (the film forming step (S200)) of forming the plurality of layers on the main surface of the substrate, and the inspection step (S300) of inspecting the substrate provided with the plurality of layers. The inspection step includes the processing step (the local etching step (S321)) and the opening inspection step (S323). In the processing step (the local etching step (S321)), as illustrated in Figs.4 and 5, concavity 7, i.e., the opening is formed at the main surface of the substrate by removing at least partially the plurality of layers in the end portion of the region provided with the plurality of layers, i.e., epitaxial films 3a - 3e. In the opening inspection step, the inspection is performed on the epitaxial films exposed in concavity 7. Further, the substrate manufacturing method includes the removal step (S600) of removing the plurality of layers from the substrate that is determined not to satisfy the predetermined criterion (i.e., that is determines as NO in the step (S400) in Fig. 1) according to the inspection result of the inspection step (S300). The step (film forming step (S200)) of forming the plurality of layers includes reformation of epitaxial films 3a - 3e as the plurality of layers on the main surface of the substrate that was subjected to the removal step (S600) of removing the plurality of layers.

Since the plurality of epitaxial films 3a - 3e can be reformed on the substrate that was determined not to satisfy the predetermined criterion according to the inspection result of the inspection step (S300). Therefore, it is possible to prevent abandoning of the substrate due to defects in the plurality of layers, and the substrate can be effectively used.

In the substrate manufacturing method described above, the removal step (S600) may include the step (polishing step (S620) in Fig. 7) of removing the plurality of layers (the plurality of epitaxial films 3a - 3 e) by polishing the surface provided with the plurality of layers of the substrate. In this case, the removal step (S600) in the invention can be executed by relatively simple equipment.

The removal step (S600) in the substrate manufacturing method described above may include the step (the etching step (S640) in Fig. 8) of removing the plurality of layers by performing physical etching on the surface provided with the plurality of layers of the substrate. The physical etching means the etching that can uniformly remove the surface layer from the whole surface of the plurality of layers (i.e., in such a state the etching rate in the thickness direction of the layer is substantially uniform over the whole surface of the layer), and particularly means the dry etching such as plasma etching or reactive ion etching. Even when the substrate is warped, the above etching can reliably remove the plurality of layers, and can prevent a problem of performing the local etching on the substrate surface when removing the plurality of layers. The plasma etching has isotropy. The Reactive Ion Etching (RIE) is an anisotropic, but either of the foregoing plasma etching and the RIE can be employed for etching the substrate surface when the etching pressure of the RIE is relative low similarly to the foregoing conditions. From the viewpoint of minimizing the damage to the substrate due to the etching, it is preferable to employ the ICPRIE or helicon-type RIE among several kinds of RIE causing less damage to the substrate.

In the foregoing substrate manufacturing method, the removal step (S600) may be configured to remove at least the layer determined not to satisfy the predetermined criterion from the plurality of layers (epitaxial films 3a - 3e). The above plurality of layers may include a layer (e.g., made of AlGaN) different in composition from the substrate (e.g., the GaN substrate), and this layer different in composition from the substrate may be removed in the foregoing removal step (S600). The plurality of layers may include a buffer layer formed on the substrate and made of GaN as well as a different layer formed on the buffer layer and made of AlGaN. The layers other than the buffer layer, and particularly the above different layer may be removed in the removal step (S600). Since the different layer made of AlGaN that may cause the warping of the substrate is removed, the warping of the substrate can be reduced after the removal step.

In the substrate inspection method or the substrate manufacturing method described above, the material of the substrate may contain a kind of material selected from the group consisting of GaN (gallium nitride), AlN (aluminum nitride) and SiC (silicon carbide). The material of epitaxial films 3a - 3e that are the layers (epitaxial growth layers) formed by the epitaxial growth method may include a kind of material selected from the group consisting of AlGaN, InGaN and GaN. The substrate made of the GaN, AlN and/or SiC is more expensive than a conventional substrate made of Si. However, the substrate manufacturing method and the substrate inspection method employed in the substrate manufacturing method according to the invention are configured to reform the plurality of layers on the substrate that is determined not to satisfy the predetermined criterion (i.e., is determined as an unacceptable substrate) according to the inspection result, i.e., on the substrate from which the plurality of layers were removed. Therefore, the method can effectively use the substrates as compared with the case where the unaccepted substrate is abandoned. Consequently, the manufacturing cost of the substrate provided with the plurality of layers can be reduced.

The substrate according to the invention (i.e., wafer 10 provided with the epitaxial layers shown in Fig. 4) is manufactured by the foregoing substrate manufacturing method. The substrate (wafer 10) is subjected to the predetermined inspection that is performed on the uppermost surface layer allowing non-destructive inspection among the plurality of layers, i.e., epitaxial layers 5, and further is performed on the region of epitaxial layers 5 exposed in the opening, i.e., concavity 7. Therefore, the substrate can have the epitaxial layers 5 of which quality is ensured more reliably than that of the substrate subjected to only the destructive inspection.

The substrate according to the invention is the substrate (wafer 10) provided at the main surface with epitaxial layers 5, i.e., the plurality of layers as illustrated in Figs. 4 and 6, and is provided at its main surface with concavity 7, i.e., the opening formed by removing at least a part of the epitaxial layers 5 at the end portion of the region provided with epitaxial layers 5. In this case, since the predetermined inspection can be performed on the portion (epitaxial film 3d in Fig. 5) of the epitaxial layers 5 exposed in concavity 7, the inspection of the film quality and the like can be performed more reliably on the portion under the uppermost surface of the epitaxial layers 5, as compared with the case where the non-destructive inspection is performed on the surface of the epitaxial layer without forming concavity 7. Therefore, the quality of epitaxial layers 5 can be inspected reliably so that the substrate of high quality can be obtained. From the substrate, as shown in Fig. 6, the elements can be obtained by forming the region (chip region 12) for forming the elements in the region where epitaxial layers 5 are formed but concavity 7 is not formed. Therefore, the substrate can be used effectively.

The substrate (wafer 10) is provided with the plurality of concavities 7 (i.e., two concavities 7 in Fig. 4) located in the end portion of the region provided with epitaxial layers 5 as shown in Fig. 4. In this case, the inspection can be performed in multiple positions on epitaxial layers 5. Therefore, the inspection of the quality and the like of epitaxial layers 5 can be performed more accurately so that it is possible to provide the substrate that has a low probability of occurrence of failures such as defects in quality of epitaxial layers 5.

The material of the above substrate may contain one kind of material selected from the group consisting of GaN, AlN and SiC, and the material of the layer may include at least one kind of material selected from the group consisting of AlGaN, InGaN and GaN. The substrate made of GaN, AlN, SiC or the like is more expensive than the conventional substrate made of Si. However, in the substrate according to the invention, the quality of the epitaxial layers 5 can be determined more accurately than the case where only the non-destructive inspection is performed for inspecting the quality of epitaxial layers 5 without forming concavity 7. Further, the elements can be obtained from the substrate subjected to the inspection. Therefore, it is possible to provide the substrate that can be used effectively.

The substrate processing method according to the invention includes the step (substrate preparing step (S610) in Fig. 7) of preparing the substrate (wafer 10) provided with the epitaxial films, and the polishing step (S620). In the polishing step (S620), the surface of the substrate provided with the epitaxial films is polished to remove the layer, which has a composition different from the substrate, in the epitaxial films. In this case, the substrate processing method according to the invention can be executed by relatively simple equipment.

The polishing step can restore the substrate to the state attained before the formation of the layer (epitaxial film) having the composition different from that of the substrate. Therefore, when a defect occurs in the epitaxial film in question, the defect can be removed together with the epitaxial film. Since the epitaxial film can be reformed on the surface of the substrate, the substrate can be effectively used.

According to the substrate processing method, the epitaxial films may include a buffer layer made of GaN and formed on the substrate, and a different epitaxial film made of AlGaN and formed on the buffer layer. In the polishing step (S620), the different epitaxial film (AlGaN layer) may be removed while remaining the above buffer layer. In this case, the substrate may be a GaN substrate. Since the different epitaxial film made of AlGaN that is most liable to cause the warp of the substrate can be removed, the warp of the substrate can be can be small after the polishing step. Accordingly, it is possible to simplify the step (finishing step (S630)) of performing finish polishing on the substrate fixed onto the holder table or the like after the polishing step.

The substrate processing step according to the invention includes the step (substrate preparing step (S610) in Fig. 8) of preparing the substrate (wafer 10) provided with the epitaxial film, and the etching step (S640). In the etching step (S640), the physical etching is effect on the surface provided with the epitaxial films of the substrate so that the layer that is different in composition from the substrate can be removed from the epitaxial films.

In this manner, the etching step (S640) can restore the substrate to the state that was attained before formation of the epitaxial film different in composition from the substrate. When a defect occurs in the epitaxial film in question, the defect can be removed together with the epitaxial film. Since the epitaxial film can be reformed on the surface of the substrate, the substrate can be used effectively.

In the substrate processing method, the epitaxial films may include the buffer layer made of GaN and formed on the substrate, and the different epitaxial film made of AlGaN and formed on the buffer layer. In the etching step (S640), the different epitaxial film may be removed while leaving the buffer layer. In this case, the substrate may be a GaN substrate. Since the different epitaxial film made of AlGaN that is most liable to cause the warp of the substrate can be removed, the warp of the substrate can be small after the etching step. Therefore, it is possible to simplify the step (finishing step (S630) in Fig. 8) of performing the finish polishing on the substrate fixed onto the holder table after the etching step.

## Claims

1. A substrate inspection method comprising the steps of:
preparing a substrate provided at its main surface with a plurality of layers (3a - 3e) (S100, S200);
forming an opening (7) at the main surface of said substrate by removing at least partially said plurality of layers in a region provided with said plurality of layers (S321);
wherein the plurality of layers are etched away at least partially from an uppermost layer to a predetermined depth by using plasma etching or etching by glow discharge and simultaneously a composition analyzing step (S322) is executed;
wherein in the step of executing the composition analyzing step (S322) the composition of the plurality of layers is analyzed by executing light emission analysis on the light that is emitted by the plasma etching, in the case plasma etching is executed in the step of etching the plurality of layers, or the composition of the plurality of layers is analyzed by measuring the wavelengths and intensities of the light that is emitted by the etching using glow discharge, in the case etching by glow discharge is executed in the step of etching the plurality of layers, and
performing an inspection on said layer (3a - 3e) exposed at the bottom in said opening (7) (S323).

2. The substrate inspection method according to claim 1, wherein
the plurality of openings (7) are formed in the region provided with said plurality of layers in said step (S321) of forming the opening, and
inspection is performed in each of said plurality of openings (7) in said step (S323, 322) of performing the inspection.

3. The substrate inspection method according to clam 1, wherein
a material of said substrate contains one kind of material selected from the group consisting of GaN, AIN and SiC, and
a material of said layer (3a - 3e) contains one kind of material selected from the group consisting of AIGaN, InGaN and GaN.

4. A method of manufacturing an element, comprising the steps of:
performing an inspection using the substrate inspection method according to claim 1, and inspecting said substrate (S300); and
forming an element in a region (12) within a region provided with said plurality of layers (3a - 3e; 5) of said substrate determined to satisfy a predetermined criterion according to a result of the inspection in said step (S300) of performing the inspection, wherein said opening (7) is formed outside said element forming region (12).

5. A method of manufacturing a substrate, comprising the steps of:
preparing a substrate (S100);
forming a plurality of layers on a main surface of said substrate (S200);
inspecting the substrate provided with said plurality of layers (S300) by using the substrate inspection method of claim 1; and
removing said plurality of layers from said substrate determined not to satisfy a predetermined criterion according to a result of the inspection in said step of inspecting the substrate (S600), wherein
said step (S200) of forming said plurality of layers includes reformation of the plurality of layers (3a - 3e) on the main surface of said substrate previously subjected to removal of said plurality of layers in said step (S600) of removing said plurality of layers.

6. The method of manufacturing the substrate according to claim 5, wherein said step (S600) of removing said plurality of layers includes a step (S620) of removing said plurality of layers by polishing the surface provided with said plurality of layers of said substrate.

7. The method of manufacturing the substrate according to claim 5, wherein said step of removing said plurality of layers includes a step (S640) of removing said plurality of layers by performing physical etching on the surface provided with said plurality of layers of said substrate.

8. The method of manufacturing the substrate according to claim 5, wherein
a material of said substrate contains one kind of material selected from the group consisting of GaN, AIN and SiC, and
a material of said layer contains one kind of material selected from the group consisting of AIGaN, InGaN and GaN.

## Patentansprüche

1. Substratprüfungsverfahren umfassend die Schritte:
Bereitstellen eines Substrats, auf dessen Hauptoberfläche eine Vielzahl von Schichten (3a - 3e) (S100, S200) vorgesehen sind;
Bilden einer Öffnung (7) auf der Hauptoberfläche des Substrats durch wenigstens teilweises Entfernen der Vielzahl von Schichten in einem Bereich, der die Vielzahl von Schichten aufweist;
wobei die Vielzahl von Schichten mithilfe eines Plasmaätzprozesses oder eines Glimmentladungsätzprozesses wenigstens teilweise von einer obersten Schicht bis zu einer vorbestimmten Tiefe weggeätzt und gleichzeitig einem Zusammensetzungsanalyseschritt (S322) unterzogen wird;
wobei in dem Zusammensetzungsanalyseschritt (S322) die Zusammensetzung der Vielzahl von Schichten analysiert wird, indem das durch den Plasmaätzprozess emittierte Licht einer Lichtemissionsanalyse unterzogen wird, für den Fall, dass ein Plasmaätzprozess in dem Schritt des Ätzens der Vielzahl von Schichten durchgeführt wurde, oder die Zusammensetzung der Vielzahl von Schichten analysiert wird, indem die Wellenlängen und Intensitäten des durch den Glimmentladungsätzprozess emittierten Lichts gemessen werden, für den Fall, dass ein Glimmentladungsätzprozess in dem Schritt des Ätzens der Vielzahl von Schichten durchgeführt wurde, und
Durchführen einer Prüfung (S323) der am Boden in der Öffnung (7) freigelegten Schicht (3a - 3e).

2. Substratprüfungsverfahren nach Anspruch 1, wobei
in dem Schritt (S321) des Bildens der Öffnung, die Vielzahl der Öffnungen (7) in einem die Vielzahl von Schichten aufweisenden Bereich gebildet wird, und
in dem Schritt des Durchführens einer Prüfung (S323, 322), eine Prüfung in jeder der Vielzahl der Öffnungen (7) durchgeführt wird.

3. Substratprüfungsverfahren nach Anspruch 1, wobei
ein Material des Substrats eine Materialart umfasst, die aus der Gruppe bestehend aus GaN, AIN und SiC ausgewählt ist, und
ein Material der Schicht (3a - 3e) eine Materialart umfasst, die aus der Gruppe bestehend aus AlGaN, InGaN und Gan ausgewählt ist.

4. Verfahren zur Herstellung eines Elements, umfassend:
Durchführen einer Prüfung unter Verwendung des Substratprüfungsverfahrens nach Anspruch 1, und Prüfen des Substrats (S300); und
Bilden eines Elements in einem Bereich (12) innerhalb eines Bereichs, der mit der Vielzahl von Schichten (3a - 3e, 5) des Substrats versehen ist, das ermittelt wurde, einen vorbestimmten Maßstab gemäß einem Prüfungsergebnis in dem Schritt (S300) des Durchführens der Prüfung zu erfüllen, wobei die Öffnung (7) außerhalb des Element bildenden Bereichs (12) ausgebildet ist.

5. Verfahren zur Herstellung eines Substrats, umfassend die Schritte:
Bereitstellen eines Substrats (S100);
Bilden einer Vielzahl von Schichten auf einer Hauptoberfläche des Substrats (S200);
Prüfen des mit der Vielzahl von Schichten versehenen Substrats (S300) unter Verwendung des Substratprüfungsverfahrens nach Anspruch 1, und
Entfernen der Vielzahl von Schichten von dem Substrat, das ermittelt wurde, nicht einen vorbestimmten Maßstab gemäß einem Prüfungsergebnis in dem Schritt des Durchführens der Prüfung (S600) zu erfüllen, wobei
der Schritt (S200) zum Bilden der Vielzahl von Schichten eine Umformung der Vielzahl von Schichten (3a - 3e) auf der Hauptoberfläche des Substrats umfasst, von dem zuvor in dem Schritt (S600) des Entfernens der Vielzahl von Schichten die Vielzahl von Schichten entfernt wurden.

6. Verfahren zur Herstellung eines Substrats nach Anspruch 5, wobei der Schritt (S600) des Entfernens der Vielzahl von Schichten einen Schritt (S620) des Entfernens der Vielzahl von Schichten durch Polieren der Oberfläche, die mit der Vielzahl von Schichten des Substrats versehen ist, umfasst.

7. Verfahren zur Herstellung eines Substrats nach Anspruch 5, wobei der Schritt des Entfernens der Vielzahl von Schichten einen Schritt (S640) des Entfernens der Vielzahl von Schichten durch Ausführen eines physikalischen Ätzprozesses auf der Oberfläche, die mit der Vielzahl von Schichten des Substrats versehen ist, umfasst.

8. Verfahren zur Herstellung eines Substrats nach Anspruch 5, wobei
ein Material des Substrats eine Materialart umfasst, die aus der Gruppe bestehend aus GaN, AIN und SiC ausgewählt ist, und
ein Material der Schicht eine Materialart umfasst, die aus der Gruppe bestehend aus AlGaN, InGaN und Gan ausgewählt ist.

## Revendications

1. Procédé d'inspection de substrat comprenant les étapes suivantes :
la préparation d'un substrat doté au niveau de sa surface principale d'une pluralité de couches (3a à 3e) (S100, S200),
la formation d'une ouverture (7) au niveau de la surface principale dudit substrat en éliminant au moins partiellement ladite pluralité de couches dans une zone dotée de ladite pluralité de couches (S321),
dans lequel la pluralité de couches est gravée au moins partiellement à partir de la couche la plus haute sur une profondeur prédéterminée en utilisant une gravure par plasma ou une gravure par décharge luminescente et dans lequel une étape d'analyse de composition (S322) est simultanément exécutée,
dans lequel, lors de l'étape d'exécution de l'étape d'analyse de composition (S322), la composition de la pluralité de couches est analysée en exécutant une analyse d'émission de lumière menée sur la lumière qui est émise par la gravure par plasma, dans le cas où une gravure par plasma est exécutée lors de l'étape de gravure de la pluralité de couches, ou bien la composition de la pluralité de couches est analysée en mesurant les longueurs d'onde et les intensités de la lumière qui est émise par la gravure utilisant une décharge luminescente, dans le cas où la gravure par décharge luminescente est exécutée lors de l'étape de gravure de la pluralité de couches, et
l'exécution d'une inspection sur ladite couche (3a à 3e) exposée au fond dans ladite ouverture (7) (S323).

2. Procédé d'inspection de substrat selon la revendication 1, dans lequel
la pluralité d'ouvertures (7) est formée dans la zone dotée de ladite pluralité de couches lors de ladite étape (S321) de formation de l'ouverture, et
l'inspection est effectuée dans chacune de ladite pluralité d'ouvertures (7) lors de ladite étape (S323, 322) d'exécution de l'inspection.

3. Procédé d'inspection de substrat selon la revendication 1, dans lequel
un matériau dudit substrat contient un type de matériau sélectionné à partir du groupe constitué de GaN, AlN et SiC, et
un matériau de ladite couche (3a à 3e) contient un type de matériau sélectionné à partir du groupe constitué de AlGaN, InGaN et GaN.

4. Procédé de fabrication d'un élément, comprenant les étapes suivantes :
l'exécution d'une inspection en utilisant le procédé d'inspection de substrat conforme à la revendication 1 et l'inspection dudit substrat (S300), et
la formation d'un élément dans une zone (12) à l'intérieur d'une zone dotée de ladite pluralité de couches (3a à 3^{e} ; 5) dudit substrat qui sont déterminées satisfaire à un critère prédéterminé en fonction d'un résultat de l'inspection lors de ladite étape (S300) d'exécution de l'inspection, dans lequel ladite ouverture (7) est formée à l'extérieur de ladite zone (12) de formation d'élément.

5. Procédé de fabrication d'un substrat, comprenant les étapes suivantes :
la préparation d'un substrat (S100),
la formation d'une pluralité de couches sur la surface principale dudit substrat (S200),
l'inspection du substrat doté de ladite pluralité de couches (S300) en utilisant le procédé d'inspection de substrat conforme à la revendication 1, et
l'élimination de ladite pluralité de couches dudit substrat qui sont déterminées ne pas satisfaire à un critère prédéterminé en fonction du résultat de l'inspection lors de ladite étape d'inspection du substrat (S600), dans lequel
ladite étape (S200) de formation de ladite pluralité de couches inclut la reformation de la pluralité de couches (3a à 3e) sur la surface principale dudit substrat précédemment soumis à l'élimination de ladite pluralité de couches lors de l'étape (S600) d'élimination de ladite pluralité de couches.

6. Procédé de fabrication du substrat selon la revendication 5, dans lequel ladite étape (S600) d'élimination de ladite pluralité de couches inclut une étape (S620) d'élimination de ladite pluralité de couches par polissage de la surface dotée de ladite pluralité de couches dudit substrat.

7. Procédé de fabrication du substrat selon la revendication 5, dans lequel ladite étape d'élimination de ladite pluralité de couches inclut une étape (S640) d'élimination de ladite pluralité de couches en exécutant une gravure physique sur la surface dotée de ladite pluralité de couches dudit substrat.

8. Procédé de fabrication du substrat selon la revendication 5, dans lequel
un matériau dudit substrat contient un type de matériau sélectionné à partir du groupe constitué de GaN, AlN et SiC, et
un matériau de ladite couche contient un type de matériau sélectionné à partir du groupe constitué de AlGaN, InGaN et GaN.
